Europäisches Patentamt

European Patent Office

Office européen des brevets

(11) Publication number: **0 148 602**
A2

(19)

# (12) EUROPEAN PATENT APPLICATION

(21) Application number: 84308599.4

(22) Date of filing: 11.12.84

(51) Int. Cl.⁴: **H 05 K 3/02, B 32 B 15/08**

(30) Priority: 09.01.84 US 569095

(43) Date of publication of application: 17.07.85
Bulletin 85/29

(84) Designated Contracting States: **BE CH DE FR GB IT LI NL**

(71) Applicant: **STAUFFER CHEMICAL COMPANY, Westport Connecticut 06881 (US)**

(72) Inventor: **Fisher, Paul David, 1303 Kimberly Road, Anderson SC 29621 (US)**
Inventor: **Panza, Robert Alan, 2700B Laguna Circle, Concord CA 94520 (US)**

(74) Representative: **Smith, Sydney et al, Elkington and Fife High Holborn House 52/54 High Holborn, London WC1V 6SH (GB)**

(54) Transfer lamination of conductive metal layers.

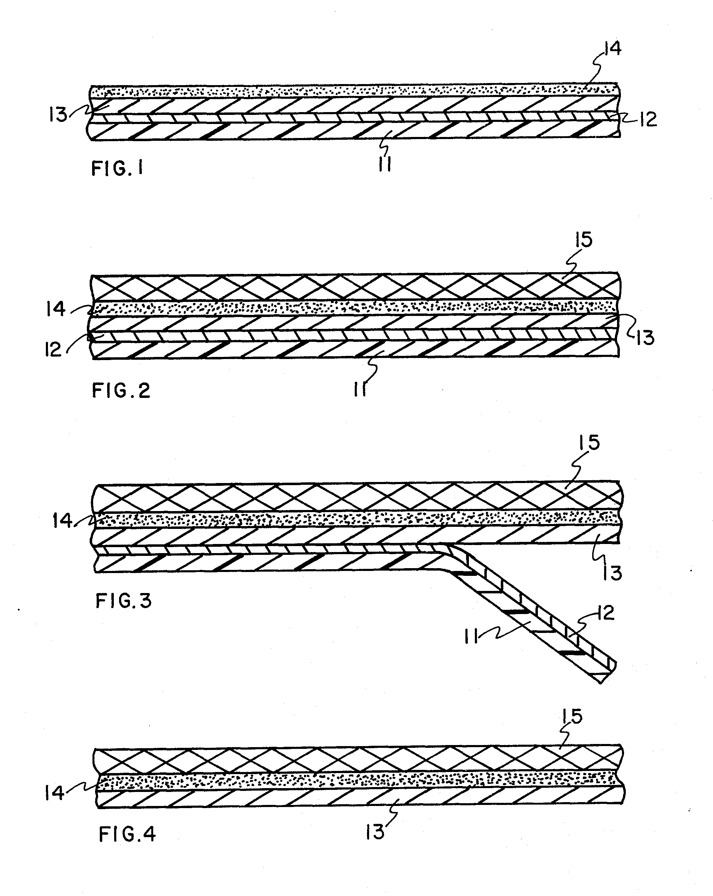

(57) Conductive metallic layers which are substantially continuous and pin hole free are adhesively bonded to a dielectric support (e.g. epoxy glass prepreg) by using a transfer laminate. The transfer laminate comprises a release coated carrier film, a metallic layer and an adhesive. After being bonded to the support, the carrier film is stripped therefrom to bond the metallic layer to the support. In fig. 1 a transfer laminate comprises a carrier film 11, a release coating 12 bonded to one side of the carrier film, an adherent metal layer 13, and an adhesive layer 14.

EP 0 148 602 A2

TRANSFER LAMINATION OF CONDUCTIVE
METAL LAYERS

## Background of the Invention

### Field of the Invention

The present invention relates to placing conductive metal layers on a dielectric substrate using a transfer lamination procedure.

### Description of the Prior Art

Transfer lamination of vapor deposited foils is shown in U. S. Patent Nos. 4,357,395 and 4,383,003 to E. Lifshin et al. In the former patent, a continuous layer of metal film is applied to a dielectric substrate by means of an electro deposited copper bonding layer with modules or dendrites, having club-headed portions, which project from the layer to provide reentrant cavities for mechanical interlocking of the film with the substrate. The latter patent achieves bonding of the continuous conductive film to the dielectric sybstrate by means of an inorganic silica or alumina bonding layer. In both of the above patents it is taught that circuit patterns can be formed from the resulting laminates by conventional subtractive or semi-additive processing.

C-7260/7323

0148602

- 2 -

## Summary of the Present Invention

The present invention relates to a transfer laminate useful in bonding a conductive metal layer to a dielectric support which comprises: (a) a carrier film; (b) a release coating on one side of the carrier film; (c) a metallic layer, which is adapted to form the conductive metal layer, bonded to the release coating; and an exposed resinous adhesive bonded to the metallic layer. The metallic layer has substantially greater preference to bonding to the adhesive, as compared to the release coating, throughout substantially the entire area of the laminate. When the adhesive is bonded to the desired dielectric support and the carrier film and adherent release coating is removed, the metallic layer adheres to the adhesive and is thereby joined to the dielectric support.

## Description of the Drawings

The Drawings, which form a portion of the present invention, schematically illustrate in Figs. 1 - 4 one embodiment of the present invention wherein:

Fig. 1 is a cross-sectional view of a transfer laminate in accordance with the present invention;

Fig. 2 shows lamination of the product of Fig. 1 to a dielectric support;

Fig. 3 shows stripping of the carrier film and release coating from the dielectric support/adhesive/conductive metal laminate; and

Fig. 4 shows the desired product having a conductive metal layer adhered to the dieleectric support by adhesive.

C-7260/7323

Detailed Description of the Present Invention

The preferred transfer laminate of the present invention is shown in Fig. 1 and comprises a carrier film 11, a release coating 12 bonded to one side of the carrier film, an adherent metal layer 13 attached to the side of the release coating remote from the carrier film, and an adhesive layer 14.

The carrier film 11 can be chosen from a wide variety of materials including metal, paper, polymers, and the like. Preferred materials, from the viewpoint of economics, include paper and thermoplastic films such as polyester(polyethylene terephthalate). Generally in a preferred embodiment the thickness of carrier film 11 can range from about 12.7 to about 76.2 microns.

In order to achieve the desired degree of smooth release of the metallic layer 13 from the carrier film 11, a suitable release coating 12 is placed on the carrier film. The thickness of this layer can be quite small, ranging from a monoatomic coating up to about 7 microns. Conventional materials can be used. Suitable release coatings include the silicones, polyurethanes, and the like.

The next layer in the transfer laminate is a conductive metal layer 13 formed of a suitable conductive metal such as copper or aluminum. The thickness of this layer can generally range from about 0.5 micron to about 3.0 microns.

The combination of metal layer 13, release coating 12 and carrier film 11 can be suitably formed by depositing the metal layer 13 onto commercially available release coated carriers, such as polyester, by using conventional deposition techniques (e.g., vacuum deposition, thermal evaporation, cathodic sputtering, electron beam evaporation, etc.).

Once the metal layer/release coating/carrier film subcombination has been formed, a suitable adhesive layer 14 can be printed onto the metal layer 13 so as to form a substantially continuous, pinhole free coating. The adhesive chosen should exhibit a sufficiently high degree of adhesion to both the metal layer 12 and dielectric support 15 to which the metal is to be bonded by the adhesive 14. It should have acceptably high thermoset characteristics so that after transfer it has good high temperature resistance and cohesiveness. In a preferred embodiment, modified epoxy or polyimide resins which are either self-crosslinking or curable with various added crosslinkers have been shown to be suitable adhesives. In addition, hydroxyl-functional polyester or polyether resins which are curable with isocyanates can be used. The adhesive can have a thickness of from about 10 to about 50 microns.

If desired, the exposed face of the adhesive pattern 14 can be covered with a release liner, e.g., of paper, to retard contamination of the adhesive with foreign matter in accordance with conventional practice.

The laminate of Fig. 1 (with or without optional release liner) is used to bond the desired adhesively bound layer of metal to a suitable dielectric support 15 by following the procedures of Figs. 2 - 4. Suitable dielectric supports are well known in the art and include polymeric materials in film and sheet form such as polyester, polyimide, glass epoxy prepreg boards, phenolic-resin paper prepregs, high temperature (e.g., polyimide) prepregs and the like. The exposed adhesive 14 of the laminate is bonded to the dielectric support 15 as shown in Fig. 2. Thereafter, the carrier film 11 and adherent release layer 12 are stripped from the resulting laminate as shown in Fig. 3 to leave the dielectric support/adhesive/metal layer product shown in Fig. 4.

As will be understood by the person of ordinary skill in the art, a variety of conventional materials may be selected as carrier film 11, release coating 12, metal layer 13 and adhesive 14. For example, various metals and polymers, as well as paper, can be used as carrier film 11. The metallic layer 13 can be various conductive metals (e.g., silver, aluminum, gold, etc., or their alloys). Similarly, the dielectric support 15 can be selected from a variety of suitable materials. Representative supports include both rigid (e.g., phenolic-paper, ceramic, etc.) as well as flexible (e.g., polyester, polyimide, PVC, etc.) support materials.

Two other aspects of the present invention relate to (1) the type of laminate intermediate, shown in Fig. 2 formed when the dielectric support is adhesively bonded to carrier film/release coating/metallic layer transfer laminate subcomponent and (2) the metal coating/adhesive/dielectric support end product shown in Fig. 4.

The laminate intermediate shown in Fig. 2 can be formed by placing adhesive on carrier film 11/release coating 12/metal 13 transfer laminate or can be placed on the dielectric support 15. In either case, bonding the dielectric support to the transfer laminate will form a novel structure which can be utilized to form the desired end product of Fig. 4 after the transfer laminate is removed to leave the desired metal layer 13.

The end product of Fig. 4 is, itself, a novel structure. The adhesive attachment of thin, deposited metal to the dielectric support is accomplished by such a structure. The metal layer is, of course, preferably pinhole and defect-free.

The present invention is further illustrated by the Examples which follow.

## EXAMPLE 1

This Example illustrates solid coverage of an adhesive for application of a thin continuous layer of conductive metal to a circuit board.

The ingredients listed below were mixed to form an epoxy adhesive composition.

| | Parts by Weight | |
|---|---|---|
| Ingredient | A | B |
| Epoxy-acrylonitrile rubber adducted resin (HELOXY 901A brand from Wilmington Chemical) | 30.0 | 30.0 |
| Mixed dicarboxylic acid anhydrides (CIBA 906 brand from Ciba-Geigy) | 24.0 | 24.0 |
| Tri(dimethylaminomethyl)phenol (CIBA DY 064 brand from Ciba Geigy) | 1.0 | - |
| 2-propylimidazole (ACTIRON NXJ 60 brand from Sythron, Inc.) | - | 1.0 |

After three days, the liquid adhesive formulations had increased only slightly in viscosity and were used to coat the metallic side of samples of copper-sputtered, silicone release-coated, kraft paper and aluminum-sputtered, kraft paper. The adhesive coated samples were dried at 150°F. (65.6°C.) for six minutes and were then laminated to a sheet of (FR-4) epoxy glass prepreg, and the transfer paper was removed. Since the above adhesives did not exhibit good adhesion between the epoxy glass and the aluminum, an alternative adhesive was used for the aluminum-coated paper:

| Ingredient | Parts by Weight |
|---|---|
| Modified polyester resin solution (ADCOTE 76 PI brand from Morton-Thiokol) | 120 |
| Modified polyester resin solution (HUGHSON 7904 brand from Lord Corporation) | 24 |
| Modified isocyanate hardener (ADCOTE 9H1 brand from Morton Thiokol) | 9 |

The aluminum-coated paper was bonded to 50.8 micron polyethylene terephthalate film.

The carrier paper was removed from both types of substrates described above leaving the aluminum bonded to the polyethylene terephthalate film and the copper bonded to the prepreg board. The surface conductivities were then measured with a Keithley 191A multimeter:

| Sample No. | Electrical Restivity (ohms) |
|---|---|
| 1 (Cu)* - A adhesive | 1.5 |
| 2 (Cu)* - B adhesive | 0.4 |
| 3 (Al)** | 3.0 |

* before transfer, the resistivity of the copper samples was 0.6 ohm.

**before transfer, the resistivity of the aluminum samples was 1.3 ohms.

A standard copper foil (1 oz/ft$^2$ or 1 gm/39 cm$^2$ gauge electrodeposited foil), for comparison, exhibited a resistivity of 0.2 ohm.

EXAMPLE 2

This Example describes the alternate use of a "hot stamp foil" instead of sputter-metallized, silicone release coated paper as a carrier. "Hot stamp foils" are commercially available materials generally having a thin gauge (about 12.7 - 25.4 microns) polyester film coated with a waxy release layer and subsequently vacuum metallized with aluminum on top of the release layer.

As in Example 1, the metallized surface was coated with the polyester-based adhesive, dried and laminated to polyester film (50.8 microns). Two types of "hot stamp foil" were prepared in this way: one produced a surface residue of the waxy release agent on the metallized surface which interfered with the surface conductivity of the metal layer. The other exhibited a resistivity of 21 ohms, as compared to 30.5 ohms prior to transfer. The first was Product No. 3193 IX from the Thermark Division of Avery Corp. The latter was Product No. ML2-701 from Transfer Print Foils.

C-7260/7323

EXAMPLE 3

This Example illustrates the bonding tenacity between polyimide film and continuous copper foil using a particular adhesive formulation. It and Examples 4 - 6, which follow illustrate screening work done to find suitable adhesives for application to metallized release film for lamination to prepreg circuit boards.

The following ingredients were mixed to form an adhesive:

| Ingredient | Parts by Weight |
|---|---|
| Epoxy-acrylonitrile rubber adducted resin (HELOXY 901A brand from Wilmington Chemicals ) | 30.0 |
| Mixed dicarboxylic acid anhydrides (CIBA 906 brand from Ciba-Geigy) | 24.0 |
| 2-propylimidazole (ACTIRON NXJ-60 brand from Synthron, Inc.) | 1.0 |
| Acetylene-terminated polyamic acid powder (THERMID LR-600 brand from National Starch and Chemical) | 10.0 |

The above formulation was coated with a No. 34 Meyer (wire-wound) rod onto a 50.8 micron thick polyimide film, dried for six minutes at 200°F. (93.3°C.), laminated to one ounce (28.3 gm.) electrodeposited copper foil, and cured for three hours at 325°F. (162.8°C.) in an air-circulating oven. The bond between polyimide film and the copper foil was 2 pounds per linear inch ( 350 Newtons/Meter (N/M)).

EXAMPLE 4

This Example illustrates various adhesives that were formulated for possible use as laminating adhesives between metallized, transferred layers and prepreg board. As in Example 3, the adhesives were prepared for screening purposes and were coated onto 50.8 micron gauge polyimide film (KAPTON brand from Du Pont) and were dried in an air-circulating oven at 200°F. (93.3°C.) for six minutes in such a way as to achieve an adhesive coating gauge, after drying, of about 25.4 microns. The coated polyimide film was then laminated to 28.3 gm/0.3 m$^2$ electrodeposited copper foil. The ingredients mixed to form the adhesives are as follows:

| | Adhesive No. | | | | |
|---|---|---|---|---|---|
| Ingredient | 1 | 2 | 3 | 4 | 5 |
| Epoxy-acrylonitrile rubber adducted resin (HELOXY 901A brand)[1] | 60.0 | 60.0 | 60.0 | – | – |
| Epoxy-acrylonitrile rubber adducted resin (HELOXY 8024 brand)[2] | – | – | – | – | 12.5 |
| Polyfunctional epoxy resin (ARALDITE MY 720 brand from Ciba Geigy)[3] | – | – | – | – | 100.0 |
| Mixed dicarboxylic acid anhydrides (CIBA HY 906 brand) | 24.0 | 27.0 | 30.0 | – | 30.0[4] |
| 2-propylimidazole (ACTIRON NXJ-60 brand) | 1.0 | 1.0 | 1.0 | – | 1.0 |
| Fluorocarbon surfactant (FC 431 brand from 3M) | 0.5 | 0.5 | 0.5 | – | 0.5 |
| Gamma-mercaptotri-methoxy-silane (SILANE A-189 from Union Carbide) | 0.2 | 0.2 | 0.2 | – | 0.2 |
| Monomeric polyimide resin (THERMID AL-600 brand from National Starch) | – | – | – | 6.5 | – |

C-7260/7323

|  | Adhesive No. | | | | |
| Ingredient | 1 | 2 | 3 | 4 | 5 |
| Adhesive Mixture[5] | – | – | – | 20.0 | – |

(1) 50 wt % epoxy resin in toluene.
(2) 60 wt % epoxy resin in toluene.
(3) N,N,N',N'-tetraglycidyl-4,4'-methylene-bis-benzamine (30 wt % in 1.8:1.0/methyl ethyl ketone:acetone).
(4) 80 parts by weight per 100 parts by weight of total epoxy.
(5) this was the adhesive used in Example 3.

After lamination, each construction employing the various adhesives 1 – 5, above, were cured in an air circulating oven at the following temperatures.

| Adhesive No. | Temperature Conditions |
| 1 | 93.3°C – 16 hrs/148.9°C – 3.5 hrs. |
| 2 | 93.3°C – 16 hrs/148.9°C – 3.5 hrs. |
| 3 | 148.9°C – 2.5 hrs. |
| 4 | 148.9°C – 3.5 hrs. |
| 5 | 150°C – 3.0 hrs/260°C – 4 hrs. |

The peel strength of the cured laminates was determined by delaminating 2.54 cm. wide strips in a T-peel arrangement on an INSTRON tensile tester at a separation rate of 5.08 cm. per minute. The results follow:

| | Peel Strength | |
| Adhesive No. | lbs/in. width | Newtons/meter |
| 1 | 4.0 | 700 |
| 2 | 1.5 | 263 |
| 3 | nil | nil |
| 4 | nil | nil |
| 5 | 4.5 | 788 |

The following additional adhesives were also formulated

| Ingredient | Adhesive No. | | | | |
|---|---|---|---|---|---|
| | 6 | 7 | 8 | 9 | 10 |
| Epoxy-acrylonitrile adducted resin (HELOXY 8024 brand)[1] | 12.5 | 12.5 | - | - | - |
| Epoxy-acrylonitrile adducted resin (HELOXY 8006 brand)[1] | - | - | 12.5 | 12.5 | 12.5 |
| Polyfunctional epoxy resin (ARALDITE MY 720 brand)[2] | 100 | 100 | 100 | 100 | 100 |
| Mixed dicarboxylic acid anhydrides (CIBA HY 906 brand) | - | - | 30 | - | - |
| Mixed polycarboxylic acid anhydrides (CIBA HY 920 brand) | 34[4] | - | - | 34 | - |
| Dispersion of solid polyamide in liquid epoxy resin (CIBA HY 940)[3] | - | 91.0[5] | - | - | 63.7 |
| Fluorocarbon surfactant (FC 431 brand) | 0.5 | 0.5 | 0.5 | 0.5 | 0.5 |
| Gamma-mercapto-trimethoxy-silane (SILANE A-189 brand) | 0.2 | 0.2 | 0.2 | 0.2 | 0.2 |
| 2-propylimidazole (ACTIRON NXJ-60 brand) | 1.0 | - | 1.0 | 1.0 | - |

(1) 60 wt % resin in toluene
(2) 30 wt % N,N,N',N'-tetraglycidyl-4,4' methylene-bis-benzamine in 1.8:1.0/methylethylketone: acetone.
(3) 70 wt % dispersion of polyamide in liquid epichloro-hydrin/bisphenol A epoxy resin in toluene with additional five grams of propylene glycol methyl ether acetate (ARCOSOLVE PM Acetate brand from Arco).
(4) 90 parts per weight per 100 parts by weight of base resin.
(5) 170 parts by weight per 100 parts by weight of base resin.

Each of the preceding adhesives 6 - 10 was cast onto a 50.8 micron thick polyimide film (KAPTON brand) with a No. 34 wire-wound Meyer casting rod and dried in an air-circulating oven at 93.3°C. for six minutes to achieve a dried adhesive layer of about 25.4 microns in thickness. The adhesive-coated films were then laminated to 28.3 gm/.3m$^2$ electrodeposited copper foil. Various oven curing cycles were used after lamination as follows:

| Adhesive No. | Temperature Conditions |
|---|---|
| 6 | 80°C - 4 hrs/140°C - 4 hrs. |
| 7 | 150°C - 3 hrs. |
| 8 | 150°C - 2.5 hrs. |
| 9 | 80°C - 2.5 hrs. |
| 10 | 80°C - 2.5 hrs. |

Peel strength values were determined, as described before:

| Adhesive No. | Peel Strength (lb/in. width) | (Newtons/meter) |
|---|---|---|
| 6 | 4.5 | 788 |
| 7 | nil | nil |
| 8 | 1.5 | 263 |
| 9 | 2.0 | 350 |
| 10 | nil | nil |

C-7260/7323

EXAMPLE 5

This Example illustrates additional embodiments wherein a variety of adhesives were tested for their adhesion characteristics in a polyimide film/adhesive/ continuous copper foil laminate. As in the previous examples the ultimate aim is a suitable adhesive for bonding a metal foil to a prepreg laminate.

The following ingredients were used to form the adhesives.

| Ingredient | Adhesive | | | |
|---|---|---|---|---|
| | A | B | C | D |
| Epoxy-rubber adduct resin (HELOXY 901A brand) | 60 | – | – | – |
| Epoxy-rubber adduct resin (HELOXY 8034 brand) | – | 12.5 | – | – |
| Epoxy-elastomer adducted resin (KELPOXY G 293-100 brand from Spencer-Kellogg) | – | – | 12.5 | – |
| Epoxy-elastomer adducted resin (KELPOXY G 272-100 brand from Spencer-Kellogg) | – | – | – | 12.5 |
| Polyfunctional epoxy resin (ARALDITE MY 720 brand) | – | 60.0 | 60.0 | 60.0 |
| Mixed dicarboxylic acid anhydrides (CIBA HY 906 brand) | 22.5 | 32.0 | 32.0 | 32.0 |
| 2-propylimidazole (ACTIRON NXJ-60 brand) | 1.0 | 1.0 | 1.0 | 1.0 |
| Fluorocarbon surfactant (FC-431 brand from 3M) | 0.1 | 0.1 | 0.1 | 0.1 |
| Gamma-mercapto-trimethoxy-silane (SILANE A-189 brand) | 0.1 | 0.1 | 0.1 | 0.1 |

C-7260/7323

| Ingredient | Adhesive | | | |
|---|---|---|---|---|
| | E | F | G | H |
| Epoxy-rubber adduct resin (HELOXY 901A brand) | 12.5 | – | 12.5 | 60.0 |
| Epoxy-rubber adduct resin (HELOXY 8024 brand) | – | 12.5 | – | – |
| Polyfunctional epoxy resin (ARALDITE MY 720 brand) | 60.0 | 60.0 | 60.0 | – |
| 2-propylimidazole (ACTIRON NXJ-60) | 1.0 | 1.0 | 1.0 | 1.0 |
| Fluorocarbon surfactant (RC-431 brand from 3M) | 0.1 | 0.1 | 0.1 | 0.1 |
| Gamma-mercaptotrimethoxy-silane (SILANE A-189 brand) | 0.1 | 0.1 | 0.1 | 0.1 |
| Isomeric mixture of methyl tetrahydrophthalic anhydride (AZCURE 910 brand) | – | – | 21.8 | 21.8 |
| Methyl tetrahydrophthalic anhydride (LEKUTHERM M brand from Mobay) | 21.8 | 21.8 | – | – |

The formulations were cast onto 50.8 micron thick polyimide film at a thickness of about 25.4 microns and were dried for 5 minutes at 93.3°C. The adhesive coated polyimide film was laminated to 23.8 gm. electrodeposited copper foil and cured for 3 hours at 148.9°.

The following T-Peel strengths were noted:

| Sample with Adhesive | Peel Strength | |
|---|---|---|
| | (lbs/linear in) | (Newtons/meter) |
| A | 2.5 | 438 |
| B | nil | nil |
| C | nil | nil |
| D | 2.5 | 438 |
| E | 4 | 701 |
| F | 3.5 | 613 |
| G | 4 | 701 |
| H | 4.8 | 841 |

C-7260/7323

0148602

## EXAMPLE 6

This Example sets forth additional adhesive formulations and the bond results obtained when placed between a polyimide film and a continuous copper foil as described in Examples 4 and 5. All amounts are in parts by weight with the anhydride being expressed in parts by weight (on a solids basis) per one hundred parts by weight of epoxy resin in the last entry.

| Ingredient | Adhesive | | | |
| --- | --- | --- | --- | --- |
| | A | B | C | D |
| Epoxy-rubber adduct resin (HELOXY 901A brand) | 60.0 | 60.0 | 60.0 | 50.0 |
| Epoxy-rubber adduct resin (HELOXY 8006 brand) | - | - | - | 10.0 |
| Isomeric anhydride mixture (AZCURE 910 brand) | 19.7 | 21.8 | 24.0 | 21.8 |
| 2-propylimidazole (ACTIRON NXJ-60 brand) | 1.0 | 1.0 | 1.0 | 1.0 |
| Fluorocarbon surfactant (FC-431 brand from 3M) | 0.1 | 0.1 | 0.1 | 0.1 |
| Gamma-mercaptotrimethoxy-silane (SILANE A-189 brand) | 0.1 | 0.1 | 0.1 | 0.1 |
| Anhydride content (phr) | 66 | 73 | 80 | 73 |

| Ingredient | Adhesive | | | |
| --- | --- | --- | --- | --- |
| | E | F | G | H |
| Epoxy-rubber adduct resin (HELOXY 901A brand) | 60.0 | 60.0 | 60.0 | 60.0 |
| Isomeric anhydride mixture (AZCURE 910 brand) | - | - | 23.1 | 26.1 |
| 2-propylimidazole (ACTIRON NXJ-60 brand) | 1.0 | 1.0 | 0.2 | 0.2 |
| Fluorocarbon surfactant (FC-431 brand from 3M) | 0.1 | 0.1 | - | - |
| Gamma-mercaptotrimethoxy-silane (SILANE A-189 brand) | 0.1 | 0.1 | - | - |
| Anhydride content (phr) | 66 | 73 | 77 | 87 |

C-7260/7323

| Ingredient | Adhesive | | | |
|---|---|---|---|---|
| | I | J | K | L |
| Epoxy-rubber adduct resin (HELOXY 901A brand) | 60.0 | 60.0 | 60.0 | 60.0 |
| Isomeric anhydride mixture (AZCURE 910 brand) | 26.1 | 27.0 | 23.0 | 23.0 |
| 2,4,6-tris(dimethylamino-methyl)phenol (ACTIRON NX-3 from Synthron) | 2.0 | - | - | - |
| N,N-dimethylbenzylamine (ACTIRON NX-91 from Synthron) | - | 0.6 | - | - |
| 2-ethyl-4-methyl imidazole (EMI-24 brand from Fike Chemicals) | - | - | 0.2 | - |
| Tris(dimethylaminomethyl) phenol (DMP-30 from Rohm and Haas) | - | - | - | 0.3 |
| Anhydride content (phr) | 87 | 90 | 77 | 77 |

The T-peel strength, when tested as described in Example 5, was as follows:

| Sample with Adhesive | Peel Strength | |
|---|---|---|
| | (lbs/linear inch) | (Newtons/meter) |
| A | 2.6 | 455 |
| B | 3.7 | 648 |
| C | 4.5 - 6.0 | 788 - 1051 |
| D | 2.0 - 8.0 | 350 - 1401 |
| E | 2.0 | 350 |
| F | 2.5 | 438 |
| G | 2.5 | 438 |
| H | 2.5 | 438 |
| I | 1.8 | 177 |
| J | 2.5 | 438 |
| K | 2.5 | 438 |
| L | 2.5 | 438 |

C-7260/7323

EXAMPLE 7

This Example illustrates a particularly preferred embodiment of the present invention in which various adhesives were formulated for use as solid coverage coatings to transfer thin, continuous metal layers to prepreg (FR-4) circuit boards. All amounts are parts by weight.

| Ingredient | Adhesive Number | | | | |
| --- | --- | --- | --- | --- | --- |
| | A | B | C | D | E |
| Epoxy-acrylonitrile rubber adducted resin (HELOXY 901A brand from Wilmington Chemicals)[1] | 45.0 | 37.5 | 45.0 | - | - |
| Epoxy-dimer acid adducted resin (HELOXY 8006 brand from Wilmington Chemicals)[2] | - | 9.0 | - | - | - |
| Polyfunctional epoxy resin (ARALDITE MY 730 from Ciba-Geigy)[3] | - | - | - | 45.0 | 45.0 |
| Mixture of brominated epoxy with phosphorus triol (FRT-TBBPA brand from FMC) | - | - | - | - | - |
| Isomeric anhydride mixture (AZCURE 910 brand from AZS) | 24.0 | 21.8 | 24.0 | - | 41.4 |
| 4, 4' Diaminodiphenyl sulfone hardener (HT 976 brand from Ciba-Geigy) | - | - | - | 14.7 | - |
| Accelerator for epoxy-anhydride (ATC-3 brand from Cordova Chemical) | - | - | 1.2 | - | - |
| 2-Propylimidazole (ACTIRON HXJ-60 brand from Synthron) | 1.0 | 1.0 | - | 1.0 | 1.0 |

C-7260/7323

| Ingredient | Adhesive Number | | | | |
|---|---|---|---|---|---|
| | F | G | H | I | J |
| Epoxy-acrylonitrile rubber adducted resin (HELOXY 901A brand from Wilmington Chemicals)[1] | – | 22.5 | – | 18.8 | 18.8 |
| Epoxy-dimer acid adducted resin (HELOXY 8006 brand from Wilmington Chemicals)[2] | – | – | – | 4.5 | 4.5 |
| Polyfunctional epoxy resin (ARALDITE MY 720 from Ciba-Geigy)[3] | – | – | 22.5 | 7.0 | 7.0 |
| Mixture of brominated epoxy with phosphorus triol (FRT-TBBPA brand from FMC) | 37.5 | 32.3 | 52.0 | 16.2 | 16.2 |
| Isomeric anhydride mixture (AZCURE 910 brand from AZS) | 13.9 | 24.0 | 38.7 | 24.0 | – |
| 4, 4' Diaminodiphenyl sulfone hardener (HT 976 brand from Ciba-Geigy) | – | – | – | – | 14.7 |
| Accelerator for epoxy-anhydride (ATC-3 brand from Cordova Chemical) | – | – | – | 1.2 | – |
| 2-Propylimidazole (ACTIRON NXJ-60 brand from Synthron) | 0.5 | 1.0 | 1.0 | – | 1.0 |

Notes:

[1] 67% by wt. solids in toluene

[2] 67% by wt. solids in toluene

[3] 67% by wt. solids in acetone/methyl ethyl ketone (50:50)

As in the previous Examples, these adhesive formulations were cast onto 76.2 micron thick polyimide film (KAPTON brand from DuPont) to achieve a dried adhesive thickness of about 25.4 microns and were dried for 5 minutes at 93.3°C. The adhesive coated polyimide film was laminated to 23.8 gm. electrodeposited copper foil and cured for 1 hour at 177°C. (with a 0.5 hour cooldown to 121°C.) at 5.62 kg/cm$^2$ in a platten press. Bond was determined as in the previous examples with the following results:

| Sample with Adhesive | Peel Strength | |
|---|---|---|
| | (lbs/linear in.) | (Newtons/meter) |
| A | 9.0 | 1580 |
| B | 2.0 - 4.0 | 350 - 700 |
| C | 6.5 | 1140 |
| D | 7.5 | 1310 |
| E | nil | nil |
| F | 6.0 - 8.0 | 1050 - 1400 |
| G | 4.5 | 790 |
| H | 6.5 | 1140 |
| I | 5.0 | 880 |
| J | nil | nil |

The preferred adhesive formulations, based on the peel values above, are adhesive numbers A, D, and F. These formulations were applied to various copper-vacuum deposited papers and films (with copper applied through the use of electron-beam vacuum-metallization process by Covac Vacuum Systems, Richmond, CA) with the adhesive next to the metallized side as follows:

C-7260/7323

| Sample No. | Type of Metallized Substrate | Adhesive No. |
|---|---|---|
| 1 | 25.4 micron  polyethylene tere-phthalate (PET) silicone coated and with micron of Cu | A |
| 2 | 25.4 micron PET silicone coated and with 1.0 micron of Cu | A |
| 3 | 25.4 micron PET silicone coated and with 1.3 micron of Cu | D |
| 4 | Release paper (No. 8714) - sili-cone  - coated and with 1.0 micron of Cu | D |
| 5 | Release paper (No. 8737) - sili-cone - coated and with 1.0 micron of Cu | F |

After the adhesive-coated metallized substrates (either PET film or paper) were dried 4 - 6 minutes at 93°C., they were laminated to FR-4 (NEMA grade) epoxy prepreg circuit board. Only samples 2 and 3 exhibited acceptable transfer of the copper layer to the prepreg after the carrier sheet was removed. These two samples were then interleaved with aluminum foil and cured in a platten press at 177°C. for 1 hour.

After removal from the press, both samples had smooth, crack-free areas of copper firmly adhered to the epoxy-glass board.

Electrical resistivity measurements were performed with a Keithley 191A multimeter with the following results:

Sample No. 2:  0.15 ohm
Sample No. 3:  0.24 ohm

These results compare favorably with electrodeposited copper foil which has a value of 0.18 ohm when measured by the same method.

C-7260/7323

The foregoing Examples illustrate certain embodiments of the present invention but should not be construed in either a limited or restrictive sense since the scope of protection sought is set forth in the claims which follow.

CLAIMS:

1.    A transfer laminate which is adapted to bond a substantially continuous and conductive layer of metal to a dielectric support which comprises:

a)    a carrier film;

b)    a release coating bonded to the carrier film on one side thereof;

c)    a conductive metallic layer, which is adapted to form the metal layer, bonded to the release coating; and

d)    an exposed resinous adhesive bonded to the metallic layer, the metallic layer having substantially greater preference to bonding to the adhesive, as compared to the release coating, throughout substantially the entire area of the laminate.

2.    A transfer laminate as claimed in claim 1 characterised in that the carrier film is formed of polyester.

3.    A transfer laminate as claimed in claim 1 or claim 2 characterised in that the release coating is formed of silicone.

4.    A transfer laminate as claimed in any of claims 1 to 3 characterised in that the metallic layer is copper.

5.    A transfer laminate as claimed in claim 1 characterised in that the adhesive comprises a modified epoxy resin curable with crosslinker.

6.    A transfer laminate as claimed in any of claims 1 to 5 characterised in that the carrier film has a thickness of from about 12.7 microns to about 76.2 microns.

7.    A transfer laminate as claimed in any of claims 1 to 6 characterised in that the metallic layer has a thickness of from about 0.5 micron to about 3.0 microns.

8.    A transfer laminate as claimed in any of claims 1 to 7 characterised in that the adhesive has a thickness of from about 10 microns to about 50 microns.

0148602

9.    A method of forming a substantially continuous and conductive metal layer on a dielectric support which comprises:

(a) adhesively bonding to the dielectric support a transfer laminate as claimed in any of claims 1 to 8;

(b) removing from the thus formed composite the carrier film and release coating of the transfer lamination so as to bond the metallic layer to the dielectric substrate.

10.    A method as claimed in claim 9 characterised in that the dielectric support is a glass epoxy prepreg board.

11.    A laminate intermediate which is adapted to be used in the bonding of a substantially continuous and conductive layer of metal to a dielectric support which comprises a transfer laminate as claimed in any of claims 1 to 8; and a dielectric support bonded to the adhesive on its side opposite to the metallic layer.

12.    A substantially continuous and conductive layer of metal which is adhesively bonded to a dielectric support, the metal having a thickness of no more than about 3 microns.

13.    A product as claimed in claim 12 characterised in that the dielectric support is a glass epoxy prepreg board.

14.    A product as claimed in claim 12 wherein the dielectric support is a glass epoxy prepreg board and the metal is copper.

15.    A product as claimed in any of claims 12 to 14 characterised in that the metal has a thickness of from about 0.5 to 3 microns.

FIG. 1

FIG. 2

FIG. 3

FIG. 4